Europäisches Patentamt

European Patent Office

Office européen des brevets

(19)

(11) Publication number: **0 145 749**
**B1**

# (12) EUROPEAN PATENT SPECIFICATION

(45) Date of publication of patent specification: **16.03.88**

(21) Application number: **84902291.8**

(22) Date of filing: **22.05.84**

(88) International application number:
**PCT/US84/00789**

(87) International publication number:
**WO 84/04739 06.12.84 Gazette 84/28**

(51) Int. Cl.⁴: **B 65 G 47/24,** H 05 K 13/00

(54) **UNIVERSAL FLAT ORIENTER FOR SEMICONDUCTOR WAFERS.**

(30) Priority: **23.05.83 US 496833**

(43) Date of publication of application:
**26.06.85 Bulletin 85/26**

(45) Publication of the grant of the patent:
**16.03.88 Bulletin 88/11**

(84) Designated Contracting States:
**AT BE CH DE FR GB LI LU NL SE**

(56) References cited:
**SU-A- 986 705
US-A-2 919 788
US-A-3 064 794
US-A-3 297 134
US-A-3 820 647
US-A-3 879 019
US-A-3 964 957
US-A-3 982 627
US-A-4 240 032
US-A-4 441 853**

(73) Proprietor: **ASQ BOATS, INC.
2650 Walnut Avenue Suite D
Tustin CA 92680 (US)**

(72) Inventor: **LEE, Steven, Nyong
4251 Vale Street
Irvine, CA 92714 (US)**

(74) Representative: **Rushton, Ronald et al
SOMMERVILLE & RUSHTON 11 Holywell Hill
St. Albans Hertfordshire AL1 1EZ (GB)**

(56) References cited:

**SOLID STATE TECHNOLOGY, vol. 26, no. 7,
July 1983, pages 115-123, New York, US; F.T.
TURNER et al.: "Advances in cassette-to-
cassette sputtercoating systems"**

**IBM Technical Disclosure Bulletin, Vol. 10, No.
6, published November 1967, V.J. Delgado,
Semiconductor Wafer Alignment Fixture, See
pages 828-829.**

Courier Press, Leamington Spa, England.

## Description

### Background of the Invention

This invention relates to apparatus for automatically rotationally orienting disk-like elements, such as semi-conductor wafers positioned in a carrier, as defined in the first part of claim 1.

In the fabrication of semiconductor devices, most of the processing steps are performed on thin disk-like wafers cut from a cylinder of semi-conductor material. Usually one or more chord-like segments are removed from the wafers to form flat edges utilized for rotationally orienting the wafers. Apparatus for so orienting individual wafers is disclosed in US—A—3820647 and US—A—3982627. In both these specifications the individual wafer is rotated until the flat edge comes into abutment with the flat surface of a slide block.

Typically, a wafer is provided a major flat edge that bears a known relationship to the crystal orientation of the semiconductor material on one face of the wafer, and a smaller or minor flat edge having a known relation to the other face of the wafer which is different from the first face.

Many of the processing steps for the wafers are performed with a batch of the wafers positioned edge-wise in slots in a carrier or cassette in generally spaced, parallel, coaxial relation. It is desirable for some operations that the wafers all be oriented uniformly in a rotational sense. That is, it is desirable that the flats on the wafers all be angularly oriented in the same manner. This can be done manually but it is a delicate, tedious operation that can result in damage to the fragile wafers.

In one previously known system using wafers with a flat edge portion, the wafers are oriented automatically by means of a motor-driven cylindrical roller or driver which extends generally parallel to the axis through the wafers and drivingly engages the lower circular edge of each wafer to cause it to rotate. The spacing of the cylindrical driver with respect to the wafers is such that the driver cannot engage the major flat edge of the wafers. Consequently, each of the wafers is rotated until the major flat edge is adjacent the driver. Another similar system is disclosed in IBM Technical Disclosure Bulletin, Volume 10, No. 6 November 1967 in an article "Semiconductor Wafer Alignment Fixture". In this system part-circular indentations are provided in the wafers so that when the wafers are in the desired orientation, the indentations are seated over the driver and cannot be further rotated.

With a driver positioned at the open bottom of the cassette, the flats all become located at the bottom of the cassette, which is one desirable orientation. Often, however, it is desirable that the flats all be at the top of a cassette. To accomplish this, it is common practice to position a second cassette on top of the first cassette in an inverted position with its normally open, upper side facing downwardly and with its slots vertically aligned with the slots in the lower cassette. By then carefully inverting the mating cassettes, the batch of wafers is transferred by gravity from the first into the other cassette, with the major flats facing upwardly. This procedure is somewhat time consuming, but more importantly runs the risk of contaminating the wafers with dust or other particulates. Further, there is the possibility of damaging individual wafers, or the entire batch, if the cassettes should be fumbled or dropped. Also, it is often desired to orient the wafer flats at some position other than the top or bottom of the wafer, and no means are provided for this other manual rotation. Other wafer handling systems are also utilized, but none are very satisfactory.

Accordingly, a need exists for an improved system for efficiently, cleanly and quickly orienting the flats on a batch of wafers.

### Summary of the Invention

In one aspect of the invention, there is provided an apparatus for automatically and selectively positioning a batch of wafers to any desired rotational orientation, when the wafers have been randomly, rotationally oriented in a cassette in generally spaced, coaxial relation. In accordance with this aspect of the invention there is provided apparatus for rotationally orienting one or more disk-like elements, i.e. wafers, such as semiconductor wafers, arranged in generally spaced, coaxial relation in a cassette and having a circular exterior edge portion interrupted by a major flat edge portion, the cassette having a plurality of slots for engaging the edges of the wafers, with a portion of the cassette being open so that the edges of the wafers are accessible and the apparatus comprising an elongated roller driver extending generally parallel to the axis of the wafers adjacent the accessible edge of the wafers and means for rotating the driver; characterised by: means for supporting the driver in a first position relative to the wafers wherein it drivingly engages the circular edge of the wafers to rotate the wafers to a first position wherein said flat edge portions are aligned adjacent the driver, the driver being spaced such that it does not rotate the wafer when the flat edge on each wafer is adjacent the driver, and means for changing the relative position between the driver and the wafers to a second position wherein the driver drivingly engages the flat edges on the wafers to rotate the wafers and continues to rotate the wafers when the driver engages the circular edge of each of the wafers; and means for interrupting the rotation of the driver in its second position after the wafers have been rotated a predetermined desired amount to obtain the desired rotational orientation of the wafers.

Thus, rotation of the driver will rotate all the wafers until their major flat edge are facing one way, e.g. downwardly, toward the driver. If the controls have been set to select this downward position, the operation is then complete. If the controls have been set to orient the major flats facing upwardly instead of downwardly, the driver is moved automatically to the second position so that it will engage the flats on the wafers and once more, cause the wafers to rotate. The rotation occurring, after the movement of the driver to the second position, is monitored by suitable controls so that the rotation is interrupted after the flats have been rotated to a desired position.

Preferably, the driver is made of a hard plastic material which will not generate particles and will not damage the wafers. A key feature that enables such a driver to rotate the wafers when engaging the flat edge is that the driver, which has an overall generally cylindrical configuration, has an exterior surface formed with a series of spaced, circumferentially extending grooves corresponding to the number of wafers in the cassette. The grooves preferably have a generally V-shape with an outer, widely angled portion wherein the sides of the groove serve as guides for guiding a respective wafer into an inner portion of the groove, which is angled more acutely so as to engage the two corners of the peripheral edges of the wafer. This provides sufficient frictional engagement to cause the driver to commence rotating the wafer.

In accordance with a second aspect of the invention there is provided a method of angularly orienting one or more disk-like wafers having a primarily circular edge interrupted by a flat-edge portion, the wafers being supported in a holder in a manner to make the edges accessible, comprising positioning a generally cylindrical driver and the holder so that the driver is positioned in driving engagement with the circular edges of the wafers; and characterised by: rotating the driver so as to rotate the wafers to a position wherein the flat-edged portion of each of the wafers is facing the driver, the driver and the holder being initially positioned so that the driver cannot rotate the wafers when the flat edge portion is facing the driver; changing the relative position between the driver and the wafers to a second position after the flat edges are aligned so that the driver will drivingly engage the flat edge portions on the wafers and once more cause the wafers to rotate; and interrupting the rotation of the driver in said second position after the wafers have been rotated to a desired, aligned, rotational orientation of the flat edge portions.

## Detailed Description of the Preferred Embodiment

Figure 1 is an exploded perspective view showing the appliance of the invention together with a cassette to be placed on the appliance and a batch of semiconductor wafers carried by the cassette.

Figure 2 is a schematic perspective view with a portion of the interior of the appliance of Figure 1 illustrating the roller driver, the cam for moving the driver frame, and the motors for driving the roller driver and the cam.

Figure 3 is an elevational view on the line 3—3 of Figure 2 illustrating the cam and the manner in which it pivots the driver frame.

Figure 4 is an enlarged, partially sectionalized view of a portion of the roller driver illustrating the exterior grooves and the manner in which they cooperate with semiconductor wafers.

Figures 5a, 5b, 5c and 5d show the roller driver in cross section illustrating the manner in which it cooperates with a semiconductor wafer during the operation of the positioner appliance of the invention.

Figure 6 is a schematic diagram illustrating the electrical circuitry, as well as some of the mechanical control components.

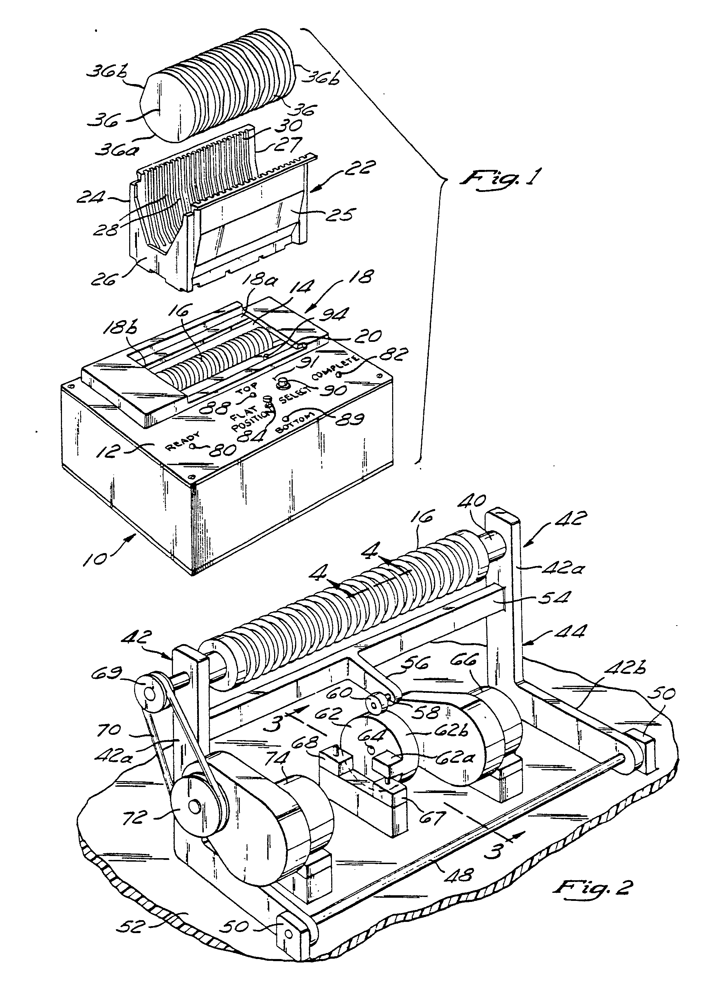

Referring now to Figure 1, it may be seen that the positioner appliance of the invention includes a generally box-like housing 10 having a top wall 12 with a generally rectangular slot 14 formed therein opening into the interior of the housing. Positioned in this slot is an elongated, generally cylindrical roller-like driver 16 which is mounted within the housing but extends upwardly into the slot such that its upper exterior surface is above the housing top wall 12.

A cassette positioning fixture 18 having a generally flat, rectangular shape is mounted on the top wall 12 of the housing, the fixture including a rectangular slot 20 which is aligned with the slot 14 in the housing top wall 12. The fixture 18 includes a cassette support surface 18a and an L-shaped guide wall 18b forming a partial border around the slot 20 in the fixture.

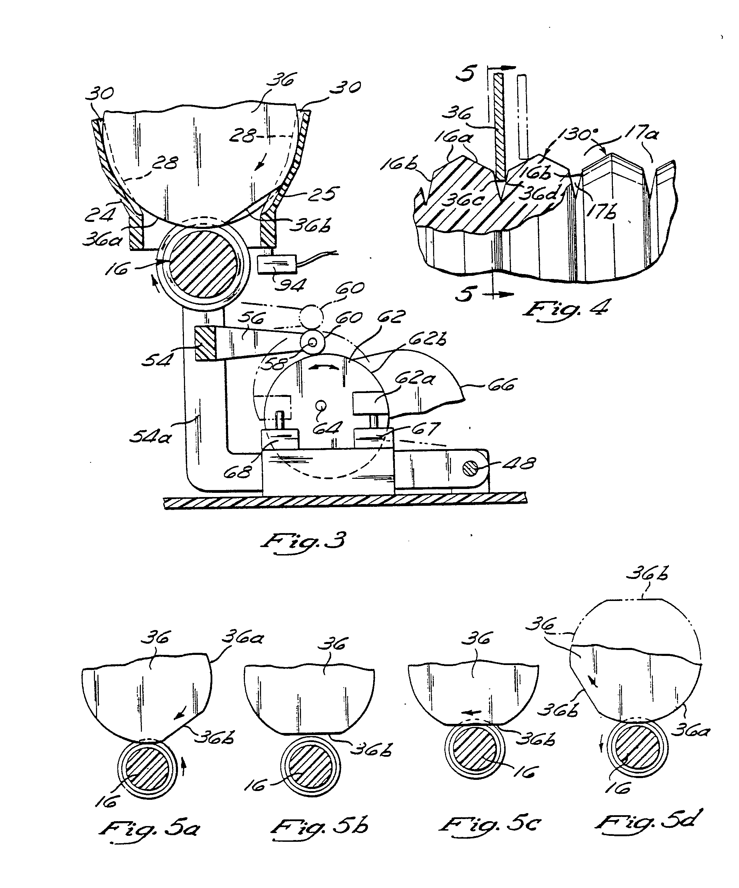

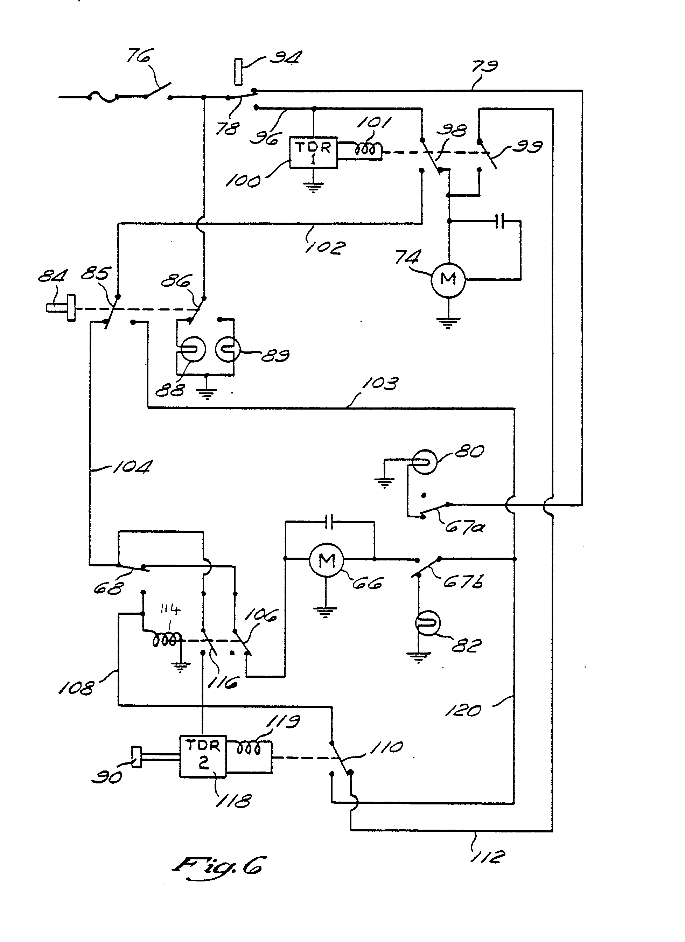

The carrier or cassette 22 is shown positioned above the positioner appliance 10 in Figure 1, to illustrate the manner in which the cassette is mounted on the positioner 10. The cassette 22 is a standard, plastic carrier commonly used for carrying a batch of semiconductor wafers 36. The cassette is provided with a pair of side wall structures 24 and 25 joined by end walls 26 and 27. The side wall structures are each provided with a plurality of spaced vertically and inwardly extending ribs 28 that define a plurality of wafer receiving slots 30. The slots are slightly larger than the wafers such that the wafers will fit easily into the slots, and the cassette side wall structures are spaced at their upper ends to receive the side edges of a wafer while the lower portions extend inwardly towards each other, generally conforming to the circular periphery of the wafer. Thus, the wafers may be easily positioned into the cassette from the top and are supported in the cassette in spaced, generally parallel, coaxial relation. As may be seen from the schematic illustration in Figure 3, the central bottom portion of the cassette is open so that the lower edges of the wafers are exposed or accessible in that area.

The wafers 36 are conventional semiconductor wafers widely used in the industry for the fabrication of semiconductor devices. They have a generally flat, disk-like configuration, having been cut from a cylinder of the semiconductor ingot. As mentioned above, a chord-like segment is cut from each disk such that the circular edge 36a of the wafer is interrupted by the flat edge 36b. This flat edge is used to indicate a directional characteristic of the crystal forming the semiconductor wafer. If there is a difference between one axial face of the wafer and the other, a second smaller flat edge (not shown) is often formed on the disk, with the major flat 36b indicating one orientation and the minor flat indicating another orientation.

Referring to Figure 2, the driver 16 is shown mounted on a shaft 40, which is, in turn, rotatably mounted on a pair of arms 42 forming major components of a frame 44. As may be seen, the arms 42 have a generally L-shaped configuration with the shaft 40 being mounted on the upper end of the vertical segments 42a of the arms, while the outer ends of the horizontal segments are pivotally secured to a rod 48 which is mounted on a pair of posts 50 secured to the bottom wall 52 of the housing 10. A cross piece 54 extends between the vertical segments of the arms spaced downwardly from the driver shaft 40 to lend stability to the structure.

A finger 56 extends outwardly from the cross piece 54 and carries a transversely extending pin 58 on which is mounted a follower roller 60. The roller 60 engages the periphery 62b of a cam 62 eccentrically mounted on a pin 64. The cam is mounted for rotation by a reversible motor 66 suitably mounted on the housing wall 52. A lug 62a is provided on one axial face of the cam adjacent the outer edge 62b of the cam. The lug 62a is shown in Figure 2 engaging a switch 67, while a second switch 68 is also in the path of the lug to be engaged when the cam is rotated about 180° in the counterclockwise direction, as viewed in Figure 2.

The left end of the shaft 40, viewed in Figure 2, has a pulley 69 mounted thereon driven by a belt 70, which, in turn is connected to a pulley 72 driven by a suitable electric motor 74.

Although the roller 16 has a generally cylindrical configuration, its exterior is actually formed with a plurality of circumferentially extending grooves 17 that are axially, equally spaced along the length of the driver. As best seen from Figure 4, the grooves 17 have an overall generally V-shaped configuration with an outer wide angled portion 17a formed by groove guide walls 16a and an inner, more accurately angled portion 17b formed by groove walls 16b. The width of the open mouth of the groove portion 17b is much greater than the thickness of the disk 36 and the guide walls 16a of one groove 17 intersect at crests 16c between adjacent grooves 17. The groove walls 16b defining the inner groove portion 17b, are spaced at their outer widest portion slightly greater than the thickness of the disk 36, and are tapered to an inner vertex. The disk 36 is thus shown with its corner edges 36c and 36d frictionally engaging the groove walls 16b.

The drive 16 is preferably made of a smooth relatively hard plastic, one suitable type being sold under the trademark Delrin. The coefficients of friction involved and the relationship between the drives and the disks is such that the disks will not rotate unless both corner edges 36c and 36d engage the groove walls 16b.

Operation

The electrical and mechanical controls for the wafer positioner will be described in combination with the description of the operation of the appliance. Referring to Figure 6, the closing of a power switch 76 applies power through a switch 78, a conductor 79, a switch 67a to a ready lamp 80. This lamp is visible through a hole in the upper wall 12 of the positioner 10, as may be seen in Figure 1, to provide an indication that the power is on and the appliance is ready to receive a cassette load of semiconductor wafers. The switch 67a is one of two switches within the switch unit 67 that is controlled by the lug 62a on the control cam 62, the other being the switch 67b which is connected to "complete" light also being shown on the upper wall 12 of the appliance 10 in Figure 1. Power, however, is not yet applied to the switch 67b such that the complete lamp 82 is not yet energized.

The operator of the appliance should also select which flat position of the wafers is desired utilizing a "flat" position control element 84 seen on the control panel in Figure 1 and in the circuit diagram of Figure 6, is provided. The control element 84 controls a switch 85 for selecting top or bottom flat orientation and also a switch 86 controlling top or bottom indicator lights 88 and 89. If some flat orientation other than top or bottom is desired, an angle selector knob 90 is rotated to a desired angle with respect to the vertical or top orientation. A suitable indicator mark on the knob 90 which, when aligned with the line 91 on the upper wall 12 of the housing indicates a top or 12 o'clock position.

With the control circuit shown as indicated in Figure 6, the top flat orientation has been selected, and the control knob 90 is as shown in Figure 1 at the top position. That is, the selector switch 85 is in the top orientation position, and the indicator light switch 86 is energizing the top light 88 upon the closing of the power switch 76. However, in obtaining top flat orientation, the wafers are first rotated to orient the flats at the bottom. Thus the initial operation to be desired is essentially the same for bottom orientation, except that control element 84, would be moved to move switch 85 to its other position which would also change switch 86.

The cassette 22 filled with a batch of wafers 36 is positioned on the fixture surface 18a of the fixture 18 with the cassette against the fixture guide wall 18b. With the cassette properly positioned, its one side wall structure 25 depresses a spring-loaded switch button 94 which is shown in Figure 1 protruding upwardly through the housing wall 12, as well as in Figure 3, and Figure 6 aligned with the cassette switch 78.

Depressing the switch 78 disconnects power to the ready lamp 80 and instead connects power through a conductor 96 through a relay switch 98 to the electric motor 74 which rotates the driver 16 through the belt 70.

With the driver 16 extending upwardly above the housing top wall 12, the lower circular edges of the wafer 36 are approximately positioned to fit within the inner portion 17b of the grooves on the exterior of the driver, as shown in solid lines in Figure 4. However, since the thickness or axial dimension of the slots in the cassette 22 are considerably larger than the thickness of the disk 36, a particular wafer may not be precisely aligned with the groove portion 17b. If not, the circular edge of the wafer will engage a groove wall 16a and be guided into the groove portion 17b with the peripheral corners 36c and 36d of the disk 36 engaging the groove walls 16b as shown in Figure 5. This frictional engagement is sufficient to cause the wafers to rotate as the driver rotates, while engagement on only one corner is not the positive drive obtained with both corners touching the groove walls is somewhat akin to a V-belt drive arrangement. A driver having a different coefficient of friction might drive a wafer with only one corner contact, but this might generate undesirable particulates and wear.

The wafers in the plastic cassette are initially positioned with their flat edges 36b randomly oriented, as illustrated in Figure 1. The wafers will continue to be rotated by the driver until each wafer has been rotated to the position wherein its flat edge 36b is facing downwardly towards the driver. The relationship between the driver and the wafers is more clearly seen in Figure 5a, wherein the driver is shown engaging a circular edge of a wafer 36. Each of the wafers will continue to be rotated until its flat edge 36a face the driver, as shown in Figure 5b. In that situation, the driver can no longer rotate the wafer since the driver is not close enough to the wafer to have both corner edges engaged in the groove portions 17b. If a wafer also has a minor flat edge, it will be so small that the roller will still engage and rotate the wafer.

Rotating the driver long enough to rotate a wafer through one revolution will result in all wafers being positioned with their flat edge downwardly, in that at the start the furthest that a wafer flat could be from the down position would be slightly less than one revolution. Consistent with this, depressing the cassette actuated switch 78 to energize the motor 74, also simultaneously energizes a time delay relay 100 which is set to measure the time required to rotate a semiconductor wafer through at least one revolution. Upon the completion of that interval, the coil 101 connected to the time delay relay will be energized to cause the switch 98 and the relay switch 99 to be drawn towards the coil, as viewed in Figure 6, with result that power is no longer applied through the switch 98 directly to the motor 74. Switch 99 provides another current path leading to the motor 74, but that path is not yet complete, as will be described below. Thus, the motor 74 is temporarily deenergized.

With the switch 98 connected to a conductor 102, current is applied to the switch 85. If the switch 85 had been moved by the control element 84 to the "flat bottom" position, current would be connected to conductor 103 and through relay switch 67b to energize the lamp 82, indicating the operation is complete. However, with the switch 85 connected for "top" orientation, as shown, power is applied through a conductor 104, cam controlled switch 68 and relay switch 106 to the reversible cam motor 66.

The cam 62 is at that point positioned, as shown in Figures 2 and 3, with its lug 62a positioned adjacent the switch 67. The motor rotates the cam in a counterclockwise direction, as shown in the drawings, causing the eccentrically mounted cam lug 62a to rotate approximately 180° to the dotted line position in Figure 3. The follower roller 60 engaging the periphery of the cam is likewise raised, causing the finger 56 and the entire frame 44 to be raised, or actually pivoted in the clockwise direction as viewed in Figure 3 around the rod 48. This movement of the frame 44 likewise moves the driver 16 to its upper or broken line position shown in Figure 3. Movement of the driver 16 towards the wafers 36 places the roller groove walls 16b into driving engagement with the flats 36a on the batch of wafers.

When the cam 62 reaches its raised position, its lug 62a actuates the switch 68 moving it to its lower position as viewed in Figure 6. This interrupts the current flow through the cam motor 66 such that the cam stops in the broken line position shown in Figure 3. Moving the cam switch 68 to its lower position completes the circuit to a conductor 108 leading to a relay switch 110, which in turn is connected by a conductor 112 to the relay switch 99, once more applying power to driver motor 74, thus once more commencing rotation of the wafers.

Actuating switch 68 also applied power to relay coil 114 causing the relay switch 116 to be closed, completing a second current path to the conductor 108 and the coil 114. Also, energizing the coil 114 opens the switch 106 so that current cannot be conducted to the cam motor 66 through the switch 68 even if switch 68 is once more moved to its solid line position shown in Figure 6.

Applying power to the conductor 108 also simultaneously provides power to the time delay relay 118 which measures the time that the driver motor 74 is allowed to operate. Since the control button 84 had been set for top flat orientation, with the control knob 90 similary set for this top orientation, the time delay relay will measure the time required to rotate the batch of wafers about 180°, bringing the flats 36b to the top position. At that point, the coil 119 connected to the time delay relay 118 will be energized causing the relay switch 110 to move to its second position, interrupting the current flow through conductor 112 leading to the driver motor 74, leaving the wafer flats in the desired top oriented position.

Movement of the relay switch 110 to its alternate position completes a connection through the conductor 120 to the cam switch 67b, which had been raised to its upper position, as viewed in Figure 6, when the cam lug 62a moved away from switch 67. Thus, power is applied through the switch 67b to the cam motor 66, but in the opposite direction to the power that had been previously applied to the cam motor. Consequently, the cam motor rotates the cam in reverse or clockwise direction, returning the cam to its solid position, as viewed in Figure 6. The cam lug 62a thus causes the switch 67b to move to its solid line position, as shown in Figure 6, once more interrupting current flow to the cam motor 65. Power is instead applied through the cam switch 67b to the light 82, which is visible on the appliance panel indicating that the wafer orientation cycle is complete.

It should be noted that although the rotation of cam 62 in a clockwise position allows switch 68 to move to its solid line position of Figure 6, the relay coil 114 is still energized through its still closed relay switch 116 such that power is applied through the conductor 120 to the "complete" indicator lamp 82. Likewise, the switch 106 is still held in an open position such that power cannot be applied to the cam motor, even though the switch 68 has returned to its solid line position. Removing the cassette of wafers allows the spring loaded button 94 to be moved upwardly, thus allowing switch 78 to be opened disconnecting power to the conductor 96 and all the components energized through that connection, including coils 101, 114, and 119, and the complete lamp 82. Instead switch 78 connects power to the ready lamp 80, indicating that the appliance is ready to receive another cassette load of wafers.

If it had been desired to orient the wafer flats to some orientation other than top or bottom, the selector knob 90 can be rotated to the desired angle with respect to top orientation. This will cause the time delay relay 118 to function to interrupt power to the driver motor 74 after the desired time interval has elapsed which is necessary to rotate the driver sufficiently to place the wafer flats in the desired orientation.

Thus, it can be seen that the invention provides a truly universal flat orienter for automatically orienting semiconductor wafers to any desired orientation.

## Claims

1. Apparatus for rotationally orienting one or more disk-like elements, i.e. wafers (36), such as semiconductor wafers, arranged in generally spaced, coaxial relation in a cassette (22) and having a circular exterior edge portion (36a) interrupted by a major flat-edged portion (36b), the cassette having a plurality of slots (30) for engaging the edges of the wafers, with a portion of the cassette (22) being open so that the edges of the wafers (36) are accessible and the apparatus comprising an elongated roller driver (16) extending generally parallel to the axis of the wafers (36) adjacent the accessible edge of the wafers (36) and means (74) for rotating the driver; characterised by:
means (44) for supporting the driver (16) in a first position relative to the wafers (36) wherein it drivingly engages the circular edge portion (36a) of each of the wafers (36) to rotate the wafers (36) to a first position wherein said flat-edged portions (36b) are aligned adjacent the driver (16), the driver (16) being spaced such that it does not rotate the wafer (36) when the flat-edged portion (36b) on each wafer (36) is adjacent the driver (16), and means for changing the relative position between the driver (16) and the wafers (36) to a second position wherein the driver drivingly engages the flat edges (36b) on the wafers (36) to rotate the wafers (36) and continues to rotate the wafers (36) when the driver (16) engages the circular edge portion (36a) of each of the wafers (36); and means (118, 119, 120) for interrupting the rotation of the driver (16) in its second position after the wafers (36) have been rotated a predetermined desired amount to obtain the desired rotational orientation of the wafers (36).

2. The apparatus of Claim 1 wherein the means for interrupting the rotation of the driver (16) includes an electrical circuit having timer means (118) for interrupting the rotation of the driver (16) after a predetermined time interval.

3. The appartus of Claim 1 wherein the exterior of the driver (16) includes a plurality of spaced circumferentially extending grooves (17) with each groove (17) adapted to receive the edge of one wafer (36).

4. The apparatus of Claim 3 wherein each groove (17) includes sidewall portions (16a, 16b) which taper from the periphery of the driver (16) towards each other to guide the edge of a wafer (36) into an aligned position wherein the wafers (36) are precisely held in spaced parallel relation.

5. The apparatus of Claim 4 wherein said groove sidewalls (16a, 16b) include a radially inner portion (16b) which drivingly engage the peripheral edges of the wafers (36).

6. The apparatus of Claim 1 wherein the exterior of said driver (16) includes a plurality of axially spaced, circumferentially extending grooves (17) for receiving the edges of said wafers (36) each of said grooves (17) having sidewalls (16a, 16b) that angle inwardly towards each other in generally V-shaped configuration, the open outer end (17a) of the grooves (17) being considerably wider than the thickness of a wafer (36) so that wafers (36) in the cassette (22) that are not precisely arranged in spaced parallel relation will be guided into such relation by the grooves (17), the radially inner portions (16b) of said groove sidewalls (16a, 16b) being angled towards each other to achieve a spacing between the groove walls (16a, 16b) less than the thickness of the wafer (36), so that the wafer periphery will engage both of the groove walls (16b).

7. The apparatus of Claim 6 wherein said groove outer, guide portions (16a) are oriented at a first angle, and said groove inner portions (16b) are oriented at a second angle which is more acute than the first angle.

8. The apparatus of Claim 1 wherein the means for supporting said driver (16) includes a pivotally mounted frame (44), movable between the first and second positions.

9. The apparatus of Claim 8 including a cam (62) for moving said frame (44) into the second position, and means (66) for rotating said cam (62) to move said frame (44) as desired.

10. The apparatus of Claim 9 and incorporating timing means (118) for timing the rotation of said driver (16) in its second position.

11. The apparatus of Claim 1 wherein the accessible edges of the wafers (36) are at the bottom of the cassette (22) and the driver (16) engages the lower edges of the wafers (36) and raises the wafers (36) in said second position when engaging the circular edges of the wafers (36).

12. The apparatus of Claim 1 including control means (84) for selecting a bottom position for the flat orientation of the wafers or a top position for the flat orientation of the wafers.

13. A method of angularly orienting one or more disk-like wafers (36) having a primarily circular edge (36a) interrupted by a flat-edged portion (36b), the wafers (36) being supported in a holder (22) in a manner to make the edges accessible, comprising positioning a generally cylindrical driver (16) and the holder (22) so that the driver (16) is positioned in driving engagement with the circular edges of the wafers (36); and characterised by:

rotating the driver (16) so as to rotate the wafers (36) to a position wherein the flat-edged portion (36b) of each of the wafers is facing the driver (16), the driver and the holder being initially positioned so that the driver (16) cannot rotate the wafers (36) when the flat-edged portion (36b) is facing the driver (16);

changing the relative position between the driver (16) and the wafers (36) to a second position after the flat-edged portions (36b) are all aligned so that the driver (16) will drivingly engage the flat-edged portions (36b) on the wafers (36) and once more cause the wafers (36) to rotate; and

interrupting the rotation of the driver (16) in said second position after the wafers (36) have been rotated to a desired, aligned, rotational orientation of the flat-edged portions (36b).

14. The method of Claim 13 including the step of monitoring the rotation of the driver (16) when it is in its second position so as control the interruption of the rotation to obtain the desired orientation.

15. The method of Claim 14 wherein said monitoring is performed by electronically timing the rotation of the driver (16) in the second position.

16. The method of any of Claims 13 to 15, wherein the driver (16) is formed with a plurality of axially spaced, circumferentially extending grooves (17) in its periphery, and said positioning step includes positioning the driver (16) so that a wafer (36) is received in each of the grooves (17), with the wafer circular edge (36a) being drivingly engaged by the driver (16) in the first position of the driver, and the flat-edged portion (36b) of the wafers being drivingly engaged by the driver grooves (17) in the second position of the driver (16).

**Patentansprüche**

1. Vorrichtung zum verdrehenden Ausrichten eines oder mehrerer scheibenartiger Elemente, z.B. Platten (36) wie Halbleiterplatten, die in einem gegenseitigen Abstand und koaxial zueinander in einer Kassette (22) angeordnet sind, eine kreisförmige Umfangskante (36a) aufweisen, die jeweils durch einen größeren, geradlinien Kantenabschnitt (36b) unterbrochen ist, mit einer Anzahl von Schlitzen (30) in der Kassette zum Erfassen der Kanten der Platte, mit einem offenen Bereich der Kassette (22), sodaß die Kanten der Platten (36) zugänglich sind, ferner mit einer langgestreckten Antriebswalze (16), die sich im wesentlichen parallel zur Achse der Platten (36) im Bereich der zugänglichen Kante der Platte (36) erstreckt, und mit Mitteln (74) zum Antreiben der Walze, dadurch gekennzeichnet, daß Mittel (44) zum Tragen der Walze (16) in einer ersten Position relativ zu den Platten (36) vorgesehen sind, wobei sie mit der Umfangskante (36a) einer jeden Platte (36) in Triebverbindung gelangt, um die Platten (36) in eine erste Position zu verdrehen, in welcher die geradlinigen Kantenabschnitte (36b) der Walze (16) benachbart ausgerichtet sind, daß die Walze (16) einen derartigen Abstand hat, daß sie die Platte (36) dann nicht verdreht, wenn sich der geradlinige Kantenabschnitt (36b) einer jeden Platte (36) in der Nähe der Walze (16) befindet, daß Mittel zum Verändern der relativen Position zwischen der Walze (16) und den Platten (36) in eine zweite Position vorgesehen sind, in welcher die Walze mit den geradlinigen Kantenabschnitten (36b) der Platten (36) in Triebverbindung gelangt, um die Platten (36) zu verdrehen und die Platten (36) weiterhin verdreht, wenn die Walze (16) die Umfangskante (36a) einer jeden Platte (36) erfaßt, und daß Mittel (18, 119, 110) vorgesehen sind, um den Umlauf der Walze (16) in ihrer zweiten Position dann zu unterbrechen, nachdem die Platten (36) um ein vorbestimmtes, gewünschtes Maß verdreht wurden, um die gewünschte Drehausrichtung der Platten (36) zu erhalten.

2. Vorrichtung nach Anspruch 1, dadurch gekennzeichnet, daß die Mittel zum Unterbrechen des Umlaufs der Walze (16) eine elektrische Schaltung mit einem Zeitschaltwerk (118) zum Unterbrechen des Umlaufs der Walze (16) nach einem vorbestimmten Zeitinternall enthalten.

3. Vorrichtung nach Anspruch 1, dadurch gekennzeichnet, daß der Mantel der Walze (16) eine Mehrzahl von einen gegenseitigen Abstand einnehmenden Umfangsnuten (17) aufweist, und daß jede Nut (17) die Kante einer Platte (36) aufzunehmen vermag.

4. Vorrichtung nach Anspruch 3, dadurch gekennzeichnet, daß jede Nut (17) Seitenwandabschnitte (16a, 16b) aufweist, die vom Umfang der Walze (16) her aufeinander zulaufen, um die Kante einer Platte (36) in eine ausgerichtete Position zu führen, in welcher Platten (36) parallel zueinander und in gegenseitigem Abstand genau gehalten sind.

5. Vorrichtung nach Anspruch 4, dadurch gekennzeichnet, daß die Seitenwände (16a, 16b) der Nuten einen radial innen Abschnitt (16b) aufweisen, der mit den Umfangskanten der Platten (36) in Triebverbindung gelangt.

6. Vorrichtung nach Anspruch 1, dadurch gekennzeichnet, daß der Mantel der Walze (16) eine Mehrzahl von einen gegenseitigen Abstand einnehmenden Umfangsnuten (17) zur Aufnahme der Kanten der Platten (36) aufweist, daß jede Nut (17) Seitenwände (16a, 16b) aufweist, die im wesentlichen V-förmig nach innen aufeinander zulaufen, daß das offene äußere Ende (17a) der Nuten (17) wesentlichen weiter als die Dicke einer Platte (36) ist, sodaß jene Platten (36) in der Kassette (22), die nicht genau parallel zueinander und in gegenseitigem Abstand angeordnet sind, in eine solche Lage durch die Nuten (17) überführt werden, und daß die radial inneren Abschnitte (16b) der Seitenwände (16a, 16b) der Nuten einen derartigen gegenseitigen Winkel miteinander bilden, daß ein Zwischenraum zwischen den Nutwänden (16a, 16b) entsteht, der geringer als die Dicke der Platte (36) ist, sodaß der Plattenumfang an beiden Nutenwänden anliegt.

7. Vorrichtung nach Anspruch 6, dadurch gekennzeichnet, daß die äußeren Führungsabschnitte (16a) der Nuten unter einem ersten Winkel ausgerichtet sind, und daß die inneren Abschnitte (16b) der Nuten unter einem zweiten Winkel ausgerichtet sind, der spitzer als der erste Winkel ist.

8. Vorrichtung nach Anspruch 1, dadurch gekennzeichnet, daß die Mittel zum Tragen der Walze (16) einen schwenkbar gelagerten Rahmen (44) aufweisen, der zwischen der ersten und der zweiten Position bewegbar ist.

9. Vorrichtung nach Anspruch 8, dadurch gekennzeichnet, daß ein Nocken (62) zum bewegen des Rahmens (44) in die zweite Position vorgesehen ist, und daß Mittel (66) zum Verdrehen des Nockens (62) vorgesehen sind, um den Rahmen (44) wunschgemäß zu bewegen.

10. Vorrichtung nach Anspruch 9 mit einem Zeitschaltwerk (118), um den Zeitpunkt der Verdrehung der Walze (16) un ihre zweite Position zu bestimmen.

11. Vorrichtung nach Anspruch 1, dadurch gekennzeichnet, daß die zugänglichen Kanten der Platten (36) im Boden der Kassette (22) vorgesehen sind, und daß die Walze (16) die unteren Kanten der Platten (36) erfaßt und die Platten (36) beim Erfassen der Umfangskanten der Platte (36) in die zweite Position anheben.

12. Vorrichtung nach Anspruch 1, dadurch gekennzeichnet, daß ein Regler (84) zum Auswählen einer Bodenposition für die flache Ausrichtung der Platten, oder einer oberen Position für die flache Ausrichtung der Platten vorgesehen ist.

13. Verfahren zum winkligen Ausrichten einer oder mehrerer scheibenartiger Platten (36) mit einer im wesentlichen kreisförmigen Kante (36a), die von einem geradlinigen Kantenabschnitt (36b) unterbrochen ist, wobei die Platten (36) von einem Halter (32) derart getragen sind, daß die Kanten zugänglich sind, umfassend das Positionieren eines im wesentlichen zylindrischen Antriebselementes (16) sowie des Halters (22) derart, daß das Antriebselement (16) mit den kreisförmigen Kanten der Platten (36) in Triebverbindung verbracht wird, gekennzeichnet durch die folgenden Verfahrensschritte:

Das Antriebselement (16) wird derart verdreht, daß die Platten (36) in eine Position verdreht werden, in welcher die geradlinigen Kantenabschnitte (36b) einer jeden Platte dem Antriebselement (16) zugewandt sind, wobei das Antriebselement und der Halter zunächst derart positioniert sind, daß das Antriebselement (16) die Platten (36) dann nicht verdrehen kann, wenn der geradlinige Kantenabschnitt (36b) dem Antriebselement (16) zugewandt ist;

die relativen Positionen zwischen dem Antriebselement (16) und den Platten (36) werden in eine zweite Position geändert, nachdem die geradlinigen Kantenabschnitte (36b) allesamt derart ausgerichtet sind, daß das Antriebselement (16) mit den geradlinigen Kantenabschnitten (36b) der Platten (36) in Triebverbindung gelangt und erneut die Platten (36) verdreht;

der Umlauf des Antriebselementes (16) in der zweiten Position wird unterbrochen, nachdem die Platten (36) in eine gewünschte, ausgerichtete Winkelposition der geradlinigen Kantenabschnitte (36b) verbracht wurden.

14. Verfahren nach Anspruch 13, dadurch gekennzeichnet, daß der Umlauf des Antriebselementes in seiner zweiten Position derart überwacht wird, daß das Unterbrechen des Umlaufes geregelt wird, um die gewünschte Ausrichtung zu erzielen.

15. Verfahren nach Anspruch 14, dadurch gekennzeichnet, daß das Überwachen durch elektronisches zeitliches Steuern des Umlaufs des Antriebselementes (16) in der zweiten Position erfolgt.

16. Verfahren nach einem der Ansprüche 13 bis 15, dadurch gekennzeichnet, daß das Antriebselement (16) eine Mehrzahl von einen gegenseitigen axialen Abstand aufweisenden Umfangsnuten (17) versehen ist, daß der Positionierschritt das Positionieren des Antriebselementes (16) umfaßt, sodaß eine Platte (36) jeweils in einer Nut (17) aufgenommen wird, wobei die Umfangskante (36a) in einer ersten Position des Antriebselementes (16) mit diesem in Triebverbindung gelangt, und daß der geradlinige Kantenabschnitt (36b) der einzelnen Platte in der zweiten Position des Antriebselementes (16) mit einer Nut (17) in Triebverbindung gelangt.

**Revendications**

1. Appareil pour orienter en rotation un ou plusieurs éléments ou plaquettes (36) en forme de disque, notamment des plaquettes semiconductrices, ces plaquettes étant arrangées de façon espacée et coaxiale dans une cassette (22) et comportant un corps extérieur circulaire (36a) interrompu par un bord plat majeur (36b), la cassette étant pourvue d'une série de rainures (30) pour recevoir les bords des plaquettes, une partie de la cassette (22) étant ouverte de telle manière que les bords des plaquettes (36) sont accessibles, et l'appareil comportant un actionneur (16) en forme de rouleau allongé disposé sensiblement parallèlement à l'axe des plaquettes (36) en face du bord accessible des plaquettes (36), ainsi que des moyens (74) pour faire tourner l'actionneur; caractérisé par:

des moyens (44) pour supporter l'actionneur (16) dans une première position par rapport aux plaquettes (36), position dans laquelle il entraîne la bord circulaire (36a) de chacune des plaquettes (36) pour faire tourner les plaquettes (36) jusqu'à une première position dans laquelle lesdits bords plats (36b) sont alignés en face de l'actionneur (16), l'actionneur (16) étant à une distance telle qu'il ne fait pas tourner les plaquettes (36) quand le bord plat (36b) de chaque plaquette (36) se trouve en face de l'actionneur (16), et des moyens pour modifier la position relative de l'actionneur (16) et des plaquettes (36) jusqu'à une seconde position dans laquelle l'actionneur entraîne les bords plats (36b) des plaquettes (36) pour faire tourner les plaquettes (36) et continue à faire tourner les plaquettes (36) quand l'actionneur (16) entraîne le bord circulaire (36a) de chacune des plaquettes (36); et des moyens (118, 119, 110) pour interrompre la rotation de l'actionneur (16) dans sa seconde position après que les plaquettes (36) ont tourné d'une quantité prédéterminée pour atteindre l'orientation voulue des plaquettes (36) au point de vue la rotation.

2. Appareil selon la revendication 1, dans lequel les moyens pour interrompre la rotation de l'actionneur (16) comprennent un circuit électrique pourvu de moyens temporisés (118) pour interrompre la rotation de l'actionneur (16) après un intervalle de temps prédéterminé.

3. Appareil selon la revendication 1, dans lequel l'extérieur de l'actionneur (16) comporte une série de gorges circonférentielles (17), chacune de ces gorges (17) étant agencée pour recevoir le bord d'une plaquette (36).

4. Appareil selon la revendication 3, dans lequel chaque gorge (17) comporte des parois latérales (16a, 16b) qui convergent l'une vers l'autre à partir de la périphérie de l'actionneur (16) pour guider le bord d'une plaquette (36) vers une position d'alignement dans laquelle les plaquettes (36) sont maintenues précisément parallèles les unes aux autres.

5. Appareil selon la revendication 4, dans lequel lesdites parois latérales (16a, 16b) des gorges comportent une partie intérieure (16b) qui est en prise contre les bords périphériques des plaquettes (36) de manière à les entraîner.

6. Appareil selon la revendication 1, dans lequel l'extérieur dudit actionneur (16) comporte une série de gorges circonférentielles (17) espacées axialement et destinées à recevoir les bords desdites plaquettes (36), chacune desdites gorges (17) comportant des parois latérales (16a, 16b) qui forment intérieurement un angle l'une vers l'autre avec une configuration générale en V, l'ouverture extérieure (17a) des gorges (17) étant considérablement plus large que l'épaisseur d'une plaquette (36), de sorte que les plaquettes (36) de la cassette (22) qui ne sont pas rangées précisément dans une disposition parallèle et espacée seront guidées vers une telle disposition par les gorges (17), les parties intérieures (16b) desdites parois latérales (16a, 16b) des gorges formant un angle l'une vers l'autre pour créer entre les parois (16a, 16b) de la gorge un espacement inférieur à l'épaisseur de la plaquette (36), de sorte que la périphérie de la plaquette sera en prise contre deux parois (16b) de la gorge.

7. Appareil selon la revendication 6, dans lequel les parties extérieures de guidage (16a) de la gorge sont orientées sous un premier angle, et les parties intérieures (16b) de la gorge sont orientées sous un second angle qui est plus aigu que le premier angle.

8. Appareil selon la revendication 1, dans lequel les moyens pour supporter ledit actionneur (16) comportent un bâti (44) monté de manière pivotante pour être mobile entre la première et la seconde position.

9. Appareil selon la revendication 8, comportant une came (62) pour amener ledit bâti (44) dans la seconde position, et des moyens (66) pour faire tourner ladite came (62) pour déplacer ledit bâti (44) de la manière voulue.

10. Appareil selon la revendication 9, comportant des moyens de temporisation (118) pour commander dans le temps la rotation de l'actionneur (16) dans sa seconde position.

11. Appareil selon la revendication 1, dans lequel les bords accessibles des plaquettes (36) se trouvent au fond de la cassette (22) et l'actionneur (16) se met en prise sur les bords inférieurs des plaquettes (36) et soulève les plaquettes (36) dans ladite seconde position quand il est en prise sur les bords circulaires des plaquettes (36).

12. Appareil selon la revendication 1, comprenant des moyens de commande (84) pour sélectionner une orientation des plaquettes avec leur bord plat en position inférieure ou une orientation avec bord plat en position supérieure.

13. Procédé pour orienter angulairement une ou plusieurs plaquettes en forme de disque (36) comportant un bord essentiellement circulaire (36a) interrompu par un bord plat (36b), les plaquettes (36) étant placées dans un support (22) de manière que leurs bords soient accessibles, dans lequel on positionne un actionneur (16) généralement cylindrique et le support (22) de telle manière que l'actionneur (16) se trouve en prise sur les bords circulaires des plaquettes (36); caractérisé en ce que:

on fait tourner l'actionneur (16) de façon à faire tourner les plaquettes (36) jusqu'à une position dans laquelle le bord plat (36b) de chaque plaquette se trouve en face de l'actionneur (16), l'actionneur et le support étant positionnés initialement de telle façon que l'actionneur (16) ne peut pas faire tourner les plaquettes (36) quand le bord plat (36b) se trouve en face de l'actionneur (16);

on modifie la position relative entre l'actionneur (16) et les plaquettes (36) jusqu'à une seconde position une fois que les bords plats (36b) sont tous alignés, de manière que l'actionneur (16) entre en prise avec les bords plats (36b) des plaquettes (36) pour les entraîner et faire de nouveau tourner les plaquettes (36); et

on interrompt la rotation de l'actionneur (16) dans ladite seconde position une fois que les plaquettes (36) ont tourné jusqu'à une orientation angulaire voulue des bords plats alignés (36b).

14. Procédé selon la revendication 13, comprenant une étape de surveillance de la rotation de l'actionneur (16) quand il est dans sa seconde position, de manière à commander l'interruption de la rotation pour obtenir l'orientation voulue.

15. Procédé selon la revendication 14, dans lequel ladite surveillance s'effectue en commandant électroniquement les temps de rotation de l'actionneur (16) dans la seconde position.

16. Procédé selon l'une des revendications 13 à 15, dans lequel l'actionneur (16) est pourvu d'une série de gorges circonférentielles (17) espacées axialement sur sa périphérie, et l'étape de positionnement comprend un positionnement de l'actionneur (16) de telle façon qu'une plaquette (36) s'engage dans chacune des gorges (17), le bord circulaire (36a) de la plaquette étant en prise sur l'actionneur (16) pour être entraîné dans la première position de l'actionneur, et bord plat (36b) des plaquettes étant en prise dans les gorges (17) de l'actionneur pour être entraîné dans la seconde position de l'actionneur (16).

0 145 749

Fig. 1

Fig. 2

1

Fig. 3

Fig. 4

Fig. 5a

Fig. 5b

Fig. 5c

Fig. 5d

*Fig. 6*